(19) Europäisches Patentamt
European Patent Office
Office européen des brevets

(11) **EP 1 935 633 A1**

(12) **DEMANDE DE BREVET EUROPEEN**

(43) Date de publication:
**25.06.2008 Bulletin 2008/26**

(51) Int Cl.:
***B32B 17/06*** (2006.01)   ***H05K 3/00*** (2006.01)

(21) Numéro de dépôt: **06126877.7**

(22) Date de dépôt: **21.12.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK RS**

(71) Demandeur: **AGC Flat Glass Europe SA**
**1170 Bruxelles (BE)**

(72) Inventeur: **La désignation de l'inventeur n'a pas encore été déposée**

(74) Mandataire: **Decamps, Alain René François et al**
**AGC Flat Glass Europe SA**
**Intellectual Property Department**
**R&D Centre**
**Rue de l'Aurore, 2**
**6040 Jumet (BE)**

(54) **Panneau translucide pour connecter des composants electroniques**

(57)   Procédé de fabrication d'un panneau translucide destiné à connecter des composants électroniques comprenant une première étape de dépôt sur un substrat translucide, d'une couche électroconductrice translucide de base, suivie d' une séquence d'étapes alternant le dépôt de couches isolantes et de couches conductrices.

Panneau translucide pour connecter des composants électroniques comprenant un substrat en verre translucide recouvert par une couche électroconductrice de base et un empilage de couches translucides par-dessus alternant les couches isolantes translucides et les couches comprenant des zones conductrices translucides.

Utilisation du panneau pour réaliser un circuit électronique transparent comprenant des composants électroniques.

EP 1 935 633 A1

**Description**

La présente invention concerne un procédé de fabrication d'un panneau translucide pour connecter des composants électroniques et le panneau obtenu par ce procédé.

On connaît les procédés de fabrication de panneaux pour connecter des composants électroniques, en particulier les panneaux circuits imprimés mono ou multicouches. Ces panneaux sont cependant formés de substrats opaques isolants et de pistes conductrices en cuivre.

L'invention s'adresse à un procédé de fabrication d'un panneau de connexion de composants électroniques, éventuellement multicouches, qui soit translucide.

A cet effet, l'invention concerne un procédé de fabrication tel que défini dans la revendication 1.

Les revendications dépendantes définissent d'autres formes possibles de réalisation de l'invention, dont certaines sont préférées.

Le procédé de fabrication selon l'invention fournit un panneau translucide. Par panneau translucide on entend désigner aussi bien un panneau complètement transparent à la lumière visible qu'un panneau ne transmettant qu'une partie de cette lumière visible et présentant un voile ("haze") en transmission qui dépasse 5 %.

Le voile d'un milieu translucide est mesuré en transmission de la lumière et est directement lié à la diffusion de la lumière dans les directions autres que celles du rayonnement lumineux incident. On prend par conséquent souvent la mesure du coefficient de transmission diffuse pour une estimation du voile d'un milieu transparent revêtu d'une couche réfléchissante.

On mesure généralement le coefficient de transmission diffuse avec un spectrophotomètre équipé d'une sphère d'intégration. Un spectrophotomètre de type Perkin-Elmer® 900 a donné d'excellents résultats. Le panneau dont le voile doit être mesuré est appliqué tangentiellement sur la sphère de façon à obturer une petite ouverture de sa surface. Un rayon incident monochromatique délivré par un dispositif monochromateur du spectrophotomètre est dirigé vers l'échantillon à mesurer obturant l'ouverture dans la sphère, selon une perpendiculaire à la surface de l'échantillon. Une ouverture opposée dans la sphère située dans la direction de la direction de la lumière incidente permet la sortie du rayon lumineux transmis à travers le panneau échantillon, la sphère piégeant tous les rayons lumineux diffus réfléchis dans toute autre direction. Un capteur photoélectrique situé ailleurs sur la surface de la sphère mesure sous un angle d'observation de 10° la lumière monochromatique diffuse totale intégrée par la sphère. Le coefficient de transmission diffuse Tvd est alors calculé comme suit, en intégrant l'ensemble des lumières diffuses monochromatiques sur la totalité de la gamme des longueurs d'onde du spectre visible :

$$T_{vd} = \frac{\sum_{\lambda=380}^{780nm} T_{vd}(\lambda) * V(\lambda) * D65(\lambda)}{\sum_{\lambda=380}^{780nm} V(\lambda) * D65(\lambda)}$$

où,
$T_{vd}(\lambda)$ est la lumière diffuse spectrale totale,
$V(\lambda)$ est la sensibilité lumineuse spectrale d'un oeil humain moyen
et $D65(\lambda)$ est la distribution spectrale relative de l'illuminant normalisé "D65".

Selon l'invention, le panneau fabriqué est destiné à connecter des circuits électroniques. Les connexions s'établissent entre les divers circuits répartis sur au moins une face du panneau, de préférence sur une seule face du panneau.

Une première étape du procédé consiste à faire un dépôt sur un substrat translucide. Les substrats rigides sont préférés. Par substrat rigide, on entend ici un corps plein de forme plate, c'est-à-dire de faible épaisseur comparée à ses autres dimensions et de résistance mécanique aux sollicitations de flexion et de torsion suffisante pour ne pas se déformer sous l'action de sollicitations extérieures que l'on rencontre couramment dans le milieu ambiant dans lequel on utilise généralement le panneau. En particulier, les substrats rigides utilisés résistent généralement bien au vent, et aux intempéries en général, que l'on rencontre dans les milieux d'utilisation de ces panneaux, y compris la glace et la neige. Le substrat peut se présenter sous la forme d'une plaque rigide constituée d'un matériau unique ou au contraire être le résultat d'un assemblage de plusieurs feuilles ou plaques du même matériau ou de matériaux différents collés ou soudés les uns aux autres. Des exemples sont des plaques en matière plastique ou en verre translucide. Les matières transparentes aux longueurs d'ondes du spectre de la lumière visible sont préférées. Parmi celles-ci, les verres inorganiques traditionnels sont préférés, en particulier les verres sodo-calciques. De préférence, le substrat comprend au moins une feuille de verre.

Selon le procédé conforme à l'invention, la première étape de dépôt sur le substrat est suivie d'au moins une fois une séquence de quatre étapes. La séquence est réalisée une seule fois dans les cas où l'on désire fabriquer un panneau sur lequel les connexions entre les composants électroniques sont réalisées par des parties de couche conductrice situées dans un même plan. On peut aussi répéter la séquence, si l'on désire fabriquer un panneau compostant des connexions réalisées par des parties de couche conductrice situées dans plusieurs plans différents disposés en empilage.

Les quatre étapes de la séquence sont les suivantes :

1. masquage temporaire d'une partie de la surface recouverte par une couche conductrice ;

2. dépôt d'une couche translucide isolante permanente sur la surface recouverte par une couche conductrice, masquée ou non à l'étape précédente;

3. enlèvement de la matière de masquage temporaire et de la matière isolante qui la recouvre, de manière à découvrir une zone de contact aux côtés d'une zone isolante ;

4. dépôt d'une couche translucide conductrice supplémentaire sur la zone isolante pour former une autre zone de contact.

A l'étape a) de la séquence, on masque au moins une partie de la surface du panneau recouverte par une couche conductrice. Ce masquage est temporaire, c'est-à-dire qu'il est réalisé au moyen de toute matière ou système qui permette son enlèvement aisé. Un exemple est le masquage au moyen d'un film autocollant isolant électrique, par exemple un film ou des bandes en matière plastique souple enduit d'une colle pelable. L'étape a) peut suivre directement la première étape de dépôt sur le substrat translucide, par exemple lorsque la séquence n'est effectuée qu'une seule fois ou encore lors de la première exécution de la séquence.

A l'étape b), on dépose une couche translucide isolante sur la surface recouverte par la couche conductrice, qu'elle ait été ou non masquée lors de l'étape a). Cette couche translucide isolante est une couche permanente, par exemple une couche de $SiO_2$.

A l'étape c), on enlève la matière de masquage déposée à l'étape a) et la matière isolante qui la recouvre, par exemple par pelage ou arrachage du film ou des bandes en plastique collées sur au moins une partie de la surface du panneau recouverte d'une couche conductrice. On découvre ainsi au moins une zone de contact conductrice aux côtés d'au moins une zone isolante.

A l'étape d) qui suit, on dépose une couche translucide conductrice supplémentaire sur la zone isolante. Cette couche conductrice est une couche permanente obtenue généralement par pulvérisation cathodique magnétron sous vide.

Dans un mode de réalisation particulier du procédé conforme à l'invention on répète au moins une fois la séquence des quatre étapes a) à d) en ne réalisant, à partir de la première répétition, l'étape de masquage a) que sur une seule des zones de contact.

Dans un autre mode de réalisation du procédé conforme à l'invention, on intercale, entre la première étape de dépôt sur le substrat translucide et l'étape a) de la première séquence, une étape de gravure de sillons dans la couche conductrice de base pour former, par enlèvement de la matière de cette couche conductrice, au moins deux pistes de conduction électrique et qu'on intercale, dans au moins une des séquences, entre l'étape c) et l'étape d) une nouvelle étape de masquage temporaire à l'aide de bandes s'étendant d'un bord à l'autre du panneau dans une direction différente de celle des pistes de conduction de manière à recouvrir les zones de contact et les zones de connexion et qu'on fait suivre la dernière étape d) de dépôt d'une couche conductrice par une nouvelle étape d'enlèvement de la matière de masquage temporaire et de la matière conductrice qui la recouvre.

Selon cet autre mode de réalisation, on masque à l'étape a) une pluralité de zones distantes centrées sur chacune des pistes de conduction.

De préférence, on s'arrange pour que la direction des bandes de la nouvelle étape de masquage temporaire et la direction des pistes de conduction forment un angle d'au moins 30 degrés. De manière avantageuse, cet angle est de 90 degrés.

L'enlèvement de la matière de la couche conductrice du processus de gravure de sillons se fait avantageusement au moyen du balayage au travers de cette couche d'un rayon laser.

Dans la première étape, on dépose sur le panneau une couche électroconductrice translucide de base. Par couche électroconductrice on entend une couche électroconductrice du type pyrolytique ou obtenue par pulvérisation cathodique magnétron sous vide ("magnetron sputtering").

Dans un premier mode de réalisation de l'invention, la couche électroconductrice est une couche pyrolytique déposée sur la surface d'une feuille de verre à des températures allant de 500 à 750 °C. De préférence, la couche pyrolytique conductrice a été déposée à des températures de 570 à 660 °C. Une couche de ce type peut être déposée directement sur le ruban de verre chaud, à la sortie de l'étape dans laquelle le verre fondu flotte à la surface d'un bain d'étain métallique liquide, dans le procédé de fabrication bien connu du verre flotté ("float glass"). Le dépôt peut être fait par pulvérisation (spray) de fines gouttes de liquide ou par dépôt chimique en phase vapeur. Avantageusement, la couche pyrolytique est une couche déposée chimiquement en phase vapeur. Généralement, la nature de cette couche pyrolytique est essentiellement du $SnO_2$ dopé avec du fluor et/ou de l'antimoine. Une couche pyrolytique consistant essentiellement en $SnO_2$ dopé avec du fluor a donné d'excellents résultats. L'épaisseur de cette couche pyrolytique doit être adaptée soigneusement afin de fournir une résistance électrique de surface adéquate. Des épaisseurs de la couche pyrolytique devraient avantageusement se situer de 250 à 500 nm. Une épaisseur d'environ 300 nm a donné d'excellents résultats. La résistance de surface d'une couche conductrice adaptée à l'invention se situe de 0,5 à 50 $\Omega/\square$. De préférence, cette résistance est de 0,8 à 15 $\Omega/\square$. Des résistances de surface de 1 à 12 $\Omega/\square$ ont donné d'excellents résultats.

Lorsqu'elle est appliquée sur du verre clair (4 mm d'épaisseur), la transmission lumineuse d'une telle couche conductrice pyrolytique n'est généralement pas inférieure à 50 % et, de préférence, pas inférieure à 75 %, la mesure étant faite sous illuminant standardisé D65 par la CIE (Commission Internationale de l'Eclairage) et avec un angle solide de 2°. Des couches fournissant une transmission lumineuse de 76 à 79 % ont donné d'excellents résultats.

Dans ce mode de réalisation, la couche conductrice a une rugosité totale de surface de 20 à 40 nm et, de préférence, de 20 à 30 nm. Par rugosité totale de surface ($R_t$) on entend la somme de la plus grande hauteur des protubérances ($R_{prot}$) et de la plus grande profondeur des puits ($R_{pit}$) mesurée à l'aide d'un microscope à force atomique. Ce dernier délivre des hauteurs individuelles $h_{ij}$ pour chaque point de la surface selon deux directions perpendiculaires i et j. $R_t$ peut être calculé comme suit :

$$R_t = R_{prot} + R_{pit}$$

où :

$$R_{prot} = \left| \max_{i,j} \left\{ h_{ij} - h_{moy} \right\} \right|$$

$$R_{pit} = \left| \min_{i,j} \left\{ h_{ij} - h_{moy} \right\} \right|$$

$$h_{moy} = \frac{1}{N} \sum_i \sum_j h_{ij}$$

N étant le nombre total de mesures.

Toute méthode connue peut être utilisée pour réaliser cette rugosité de surface. De bons résultats ont été obtenus avec un verre "float" revêtu d'une couche électroconductrice qui a été polie mécaniquement à l'aide d'abrasifs pendant le temps nécessaire à l'obtention de la rugosité désirée.

Dans un deuxième mode de réalisation de la couche électroconductrice de base, celle-ci est une couche obtenue par pulvérisation cathodique magnétron sous vide ("magnetron sputtering"). Par exemple, la couche peut être une couche tendre constituée d'un empilage des couches élémentaires suivantes :

$$TiO_2 / ZnO / Ag / Ti / ZnO / SnO_2$$

La résistance de surface de ces couches tendres est généralement de 1 à 20 $\Omega/\square$ et, de préférence de 1 à 10 $\Omega/\square$. Une valeur de résistance de surface de 5 $\Omega/\square$ a donné d'excellents résultats.

Lorsqu'elle est appliquée sur du verre clair (4 mm d'épaisseur), la transmission lumineuse d'une telle couche conductrice n'est généralement pas inférieure à 40 % et, de préférence, pas inférieure à 80 %, la mesure étant faite sous illuminant standardisé D65 par la CIE (Commission Internationale de l'Eclairage) et avec un angle solide de 2°.

La couche conductrice magnétron peut aussi être constituée d'un empilage qui comprend une couche électroconductrice Zn dopé Al ou encore une couche In dopé Sn (couche "ITO"). La résistance de surface de ces couches est d'environ 4 à 50 $\Omega/\square$ et, de préférence d'environ 4 à 15 $\Omega/\square$.

La transmission lumineuse d'une telle couche conductrice appliquée sur du verre clair (4 mm d'épaisseur) n'est généralement pas inférieure à 80 % et, de préférence 84 %, la mesure étant faite sous illuminant standardisé D65 par la CIE (Commission Internationale de l'Eclairage) et avec un angle solide de 2°.

On préfère généralement les couches pyrolytiques aux couches magnétron, en raison de leur résistance mécanique à la rayure plus élevée.

Selon l'invention, les couches translucides conductrices supplémentaires sont le plus souvent des couches résultant d'une pulvérisation cathodique sous vide ("magnetron sputtering").

L'invention concerne aussi un panneau translucide pour connecter des composants électroniques.

A cet effet, l'invention concerne un panneau tel que défini dans la revendication 12.

Selon l'invention, le panneau translucide comprend un substrat en verre translucide.

Par verre translucide on entend désigner, comme dans le procédé conforme à l'invention, à la fois un verre complètement transparent à la lumière visible ainsi qu'un verre ne transmettant qu'une partie de cette lumière visible et présentant un voile ("haze") en transmission qui dépasse 5 %.

D'une manière générale, dans le panneau selon l'invention, on entend donner aux termes employés la même signification que celle donnée aux termes correspondants employés pour définir et décrire le procédé conforme à l'invention.

Le verre translucide conforme au panneau selon l'invention est de préférence un verre clair non coloré dans la masse.

On préfère aussi que dans ce panneau, la couche électroconductrice de base soit une couche pyrolytique translucide déposée par spray de liquide.

En variante, cette couche électroconductrice de base peut aussi être une couche pyrolytique translucide déposée par la technique CVD. Cette couche est par exemple une couche de $SnO_2$ dopé avec du fluor et/ou de l'antimoine.

Dans une autre variante non préférée, la couche électroconductrice de base peut aussi résulter d'une pulvérisation cathodique sous vide ("magnetron sputtering").

Le plus souvent, les zones conductrices des couches de l'empilage autres que la couche de base résultent d'une pulvérisation cathodique sous vide ("magnetron sputtering"). Par exemple, ces couches sont elles-mêmes un empilage de couches élémentaires $TiO_2$ /ZnO / Ag / Ti / ZnO / $SnO_2$.

L'invention concerne enfin aussi l'utilisation du panneau conforme à l'invention qui vient d'être décrit pour réaliser un circuit électronique transparent comprenant des composants électroniques.

En particulier, on utilise ce panneau pour réaliser un circuit électronique transparent comprenant des diodes électroluminescentes (LED's).

## Revendications

1. Procédé de fabrication d'un panneau translucide destiné à connecter des composants électroniques, **caractérisé en ce qu'**il comprend une première étape de dépôt sur un substrat translucide, d'une couche électroconductrice translucide de base, suivie d'au moins une fois la séquence des quatre étapes suivantes :

2. masquage temporaire d'une partie de la surface recouverte par une couche conductrice ;

3. dépôt d'une couche translucide isolante permanente sur la surface recouverte par une couche conductrice, masquée ou non à l'étape précédente ;

4. enlèvement de la matière de masquage temporaire et de la matière isolante qui la recouvre, de manière à découvrir une zone de contact aux côtés d'une zone isolante ;

5. dépôt d'une couche translucide conductrice supplémentaire sur la zone isolante pour former une autre zone de contact.

6. Procédé de fabrication d'un panneau translucide selon la revendication précédente **caractérisé en ce que** la séquence des quatre étapes a) à d) est répétée au moins une fois en ne réalisant, à partir de la première répétition, l'étape de masquage a) que sur une seule des zones de contact.

7. Procédé de fabrication d'un panneau translucide selon une quelconque des revendications précédentes, **caractérisé en ce qu'**on intercale, entre la première étape de dépôt sur le substrat translucide et l'étape a) de la première séquence, une étape de gravure de sillons dans la couche conductrice de base pour former, par enlèvement de la matière de cette couche conductrice, au moins deux pistes de conduction électrique et qu'on intercale, dans au moins une des séquences, entre l'étape c) et l'étape d) une nouvelle étape de masquage temporaire à l'aide de bandes s'étendant d'un bord à l'autre du panneau dans une direction différente de celle des pistes de conduction de manière à recouvrir les zones de contact et les zones de connexion et qu'on fait suivre la dernière étape d) de dépôt d'une couche conductrice par une nouvelle étape d'enlèvement de la matière de masquage temporaire et de la matière conductrice qui la recouvre.

8. Procédé de fabrication d'un panneau translucide selon la revendication précédente, **caractérisé en ce qu'**à l'étape a) on masque une pluralité de zones distantes centrées sur chacune des pistes de conduction.

9. Procédé de fabrication d'un panneau translucide selon une quelconque des revendications 3 et 4, **caractérisé en ce que** la direction des bandes de la nouvelle étape de masquage temporaire et la direction des pistes de conduction forment un angle d'au moins 30 degrés.

10. Procédé de fabrication d'un panneau translucide selon la revendication précédente, **caractérisé en ce que** l'angle est de 90 degrés.

11. Procédé de fabrication d'un panneau translucide selon une quelconque des revendications 4 à 6, **caractérisé en ce que**, dans l'étape de gravure de sillons, l'enlèvement de matière dans la couche conductrice s'effectue par brûlage de la matière conductrice de la couche base à l'intervention du balayage par un rayon laser.

12. Procédé de fabrication d'un panneau translucide selon une quelconque des revendications précédentes, **caractérisé en ce que** la couche électroconductrice de base est une couche pyrolytique translucide déposée par spray de liquide.

13. Procédé de fabrication d'un panneau translucide selon une quelconque des revendications 1 à 7, **caractérisé en ce que** la couche électroconductrice de base est une couche pyrolytique translucide déposée par la technique CVD.

14. Procédé de fabrication d'un panneau translucide selon une quelconque des revendications 1 à 7, **caractérisé en ce que** la couche électroconductrice translucide de base résulte d'une pulvérisation cathodique sous vide ("magnetron sputtering").

15. Procédé de fabrication d'un panneau translucide selon une quelconque des revendications précédentes, **caractérisé en ce que** les couches translucides conductrices supplémentaires sont des couches résultant d'une pulvérisation cathodique sous vide ("magnetron sputtering").

16. Panneau translucide pour connecter des composants électroniques, **caractérisé en ce qu'**il comprend un substrat en verre translucide recouvert par une couche électroconductrice de base et un empilage de couches translucides par-dessus alternant les couches isolantes translucides et les couches comprenant des zones conductrices translucides.

17. Panneau translucide selon la revendication précédente, **caractérisé en ce que** le verre translucide est un verre clair non coloré dans la masse.

18. Panneau translucide selon une quelconque des revendications 12 et 13, **caractérisé en ce que** la couche électroconductrice de base est une couche pyrolytique translucide déposée par spray de liquide.

19. Panneau translucide selon une quelconque des revendications 12 et 13, **caractérisé en ce que** la couche électroconductrice de base est une couche pyrolytique translucide déposée par la technique CVD.

20. Panneau translucide selon la revendication précédente, **caractérisé en ce que** la couche électroconductrice de base est une couche de $SnO_2$ dopé avec du fluor et/ou de l'antimoine.

21. Panneau translucide selon une quelconque des revendications 12 et 13, **caractérisé en ce que** la couche électroconductrice de base résulte d'une pulvérisation cathodique sous vide ("magnetron sputtering").

22. Panneau translucide selon une quelconque des revendications 12 à 17, **caractérisé en ce que** les zones conductrices des couches de l'empilage autres que la couche de base résultent d'une pulvérisation cathodique sous vide ("magnetron sputtering").

23. Panneau translucide selon une quelconque des revendications 12 à 18, **caractérisé en ce qu'**au moins une des couches magnétron est constituée elle-même d'un empilage de couches élémentaires $TiO_2$ / ZnO / Ag / Ti / ZnO / $SnO_2$.

24. Utilisation du panneau selon une quelconque des revendications 12 à 19 pour réaliser un circuit électronique transparent comprenant des composants électroniques.

25. Utilisation du panneau selon la revendication précédente, **caractérisé en ce que** les composants électroniques présents sur le panneau comprennent des diodes électroluminescentes (LED's).

**Office européen des brevets**

**RAPPORT DE RECHERCHE EUROPEENNE**

Numéro de la demande

EP 06 12 6877

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | GB 1 165 565 A (INTERNAT COMPUTERS LTD FORMERL [GB]) 1 octobre 1969 (1969-10-01) * le document en entier * ----- | 1,2,8-11 | INV. B32B17/06 H05K3/00 |
| X | WO 2004/062908 A (GLAVERBEL [BE]; LEFEVRE HUGUES [BE]) 29 juillet 2004 (2004-07-29) | 12-21 | |
| Y | * pages 1-8 * ----- | 1,2,8-11 | |
| X | EP 0 207 181 A (LIN CHII HSIUNG) 7 janvier 1987 (1987-01-07) | 12,13 | |
| Y | * page 6, ligne 1-23; figure 2 * ----- | 1,2 | |
| X | WO 01/82378 A (SCHOTT GLAS [DE]; ZEISS STIFTUNG [DE]; ZENKER THOMAS [DE]; THIEMANN CH) 1 novembre 2001 (2001-11-01) * le document en entier * ----- | 12, 14-18, 20,21 | |
| A | US 2005/153107 A1 (IIJIMA TADAYOSHI [JP]) 14 juillet 2005 (2005-07-14) * le document en entier * ----- | 1-21 | |
| A | US 4 353 952 A (BROWN LAWRENCE E ET AL) 12 octobre 1982 (1982-10-12) * le document en entier * ----- | 1-21 | DOMAINES TECHNIQUES RECHERCHES (IPC) H05K B32B B05D |

Le présent rapport a été établi pour toutes les revendications

| Lieu de la recherche | Date d'achèvement de la recherche | Examinateur |
|---|---|---|
| Munich | 14 juin 2007 | Aubry, Sandrine |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                                             
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 06 12 6877

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

14-06-2007

| Document brevet cité au rapport de recherche | | Date de publication | Membre(s) de la famille de brevet(s) | | Date de publication |
|---|---|---|---|---|---|
| GB 1165565 | A | 01-10-1969 | AUCUN | | |
| WO 2004062908 | A | 29-07-2004 | US | 2006275599 A1 | 07-12-2006 |
| EP 0207181 | A | 07-01-1987 | AUCUN | | |
| WO 0182378 | A | 01-11-2001 | AT | 360891 T | 15-05-2007 |
| | | | AU | 5221801 A | 07-11-2001 |
| | | | DE | 10019888 A1 | 31-10-2001 |
| | | | EP | 1275153 A1 | 15-01-2003 |
| US 2005153107 | A1 | 14-07-2005 | AUCUN | | |
| US 4353952 | A | 12-10-1982 | AUCUN | | |

EPO FORM P0460

Pour tout renseignement concernant cette annexe : voir Journal Officiel de l'Office européen des brevets, No.12/82